(19) Europäisches Patentamt
European Patent Office
Office européen des brevets

(11) Publication number: **0 188 615 B1**

# (12) EUROPEAN PATENT SPECIFICATION

(45) Date of publication of patent specification: **05.04.89**

(51) Int. Cl.⁴: **H 05 K 3/12**

(21) Application number: **84902942.6**

(22) Date of filing: **26.07.84**

(86) International application number:
**PCT/JP84/00380**

(87) International publication number:
**WO 86/01067 13.02.86 Gazette 86/04**

## (54) METHOD OF AND APPARATUS FOR FORMING THICK-FILM CIRCUIT.

(43) Date of publication of application:
**30.07.86 Bulletin 86/31**

(45) Publication of the grant of the patent:
**05.04.89 Bulletin 89/14**

(84) Designated Contracting States:
**DE FR GB**

(56) References cited:
**EP-A-0 113 979**
**JP-A-59 111 386**
**JP-A-59 112 685**
**JP-A-59 113 686**
**US-A-4 291 642**

(73) Proprietor: **Matsushita Electric Industrial Co., Ltd.**
**1006, Oaza Kadoma**
**Kadoma-shi Osaka-fu, 571 (JP)**

(72) Inventor: **MAEDA, Yukio**
**1-44-30, Himurodai Hirakata-shi**
**Osaka (JP)**
Inventor: **KUDOU, Shinichi**
**14-1-126, Kunimatsucho Neyagawa-shi**
**Osaka (JP)**
Inventor: **KABESHITA, Akira**
**4-9-107, Ikuno Katano-shi**
**Osaka (JP)**

(74) Representative: **Grams, Klaus Dieter, Dipl.-Ing. et al**
**Patentanwaltsbüro Tiedtke-Bühling-Kinne-Grupe-Pellmann-Grams-Struif Winter-Roth**
**Bavariaring 4**
**D-8000 München 2 (DE)**

**EP 0 188 615 B1**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

## Description

The present invention relates to a method of and an apparatus for forming a thick film circuit which is capable of being adapted for broadcasting radio receivers, television receivers, communication equipment, measuring control equipment, and so on, in particular to a method of forming a thick film circuit which is capable of accurately drawing a thin and wide line in a short time.

A thick film circuit has been hitherto formed in accordance with the screen printing method for mass production, while it is attempted to form such a thick film circuit by means of the drawing method using a drawing nozzle. In trial manufacturing, the screen printing method requires the design and manufacture of the screen for each thick film circuit, taking a long time. On the other hand, the drawing method does not require such screens and therefore a new circuit pattern can be made in a short time, making possible to shorten the time period required for development.

A conventional drawing method is illustrated in Fig. 1, where a drawing nozzle 3 has a circular paste discharging hole 4 for discharging a thick film paste 1 and is relatively moved with respect to a substrate 2 to thereby apply the thick film paste 1 on a surface of the substrate 2 so as to form a desired circuit pattern. This drawing method is useful for drawing a narrow line. Fig. 2 is an illustration of an end portion of the drawing nozzle 3. Generally, the paste discharging hole 4 has a diameter of 100 to 300 μm. Fig. 3 is an illustration of the cross-section of the paste drawn by the drawing nozzle 3 having a circular paste discharging hole, which is measured by a surface roughness measuring device after burning. As can be seen from Fig. 3, the configuration of the cross-section is a semicircle and the thickness of the center portion is greater. Therefore, in cases where a wide line is drawn by increasing the diameter of the nozzle, the thickness thereof increases so that difficulty is encountered to draw a wide line with thin thickness. Particularly, in the laser trimming process performed for adjusting the resistance value of a resistor paste after burning, the large thickness is rendering difficult the trimming. Even if the trimming is performed by increasing the power output of the laser or by extending the time, a micro-crack is occurring in the resistor portion due to high temperature and therefore the resistance value varies with time, resulting in lowering the reliability. Generally, the resistor paste is less than 12 μm in film thickness after burning and is about 1.0 mm in width. Using the circular paste discharging hole and keeping the film thickness to less than 12 μm, the maximum width of a line is only 150 μm. In order to eliminate this problem it has been hitherto employed a method in which a thin and wide line is formed by drawing a plurality of narrow lines to be close to each other. However, this method takes a long time, and the thickness of the connection portions becomes uneven and the resistance value becomes unstable, resulting in a deterioration of quality.

In order to eliminate these problems, it has been proposed in EP—A—0 113 979 a method of forming a thick film circuit pattern, in which a nozzle is used the paste discharging hole of which has an elongated configuration. The elongated side of the hole of this known nozzle is oriented at an angle relative to the direction of movement of the nozzle. Although this known method allows to form thin and wide lines of relatively great uniformity, it has become apparent that it should be possible to form thin and wide lines having a still better uniformity.

It hence is the object of the present invention to provide a method and an apparatus of forming a thick film circuit wherein thin and wide lines having a very great uniformity are achievable.

According to the present invention this object is achieved by the advantageous measures as indicated in claim 1 and 4.

According to claim 1 there is provided a method of forming a thick film circuit wherein the drawing nozzle is being rotated about an axis of rotation perpendicular to the substrate so that the longitudinal direction of the elongated hole is always normal to the direction in which the drawing head is moved. The axis of rotation of the drawing nozzle furthermore is selected such that it is substantially passing through the center of the paste discharging hole.

Since the drawing nozzle is arranged to be freely rotated, the drawing can efficiently be made in optional directions by one drawing head. In addition, since the center of rotation of the drawing nozzle substantially passes through the center of the paste discharging hole, preferably, with error smaller than 0.05 mm, the rotation of the drawing nozzle does not cause variation of position of the center of the paste discharging hole relative to the substrate irrespective of any changes of the drawing direction. Therefore, when the drawing nozzle is rotated for the purpose of changing the drawing direction, it is not required to correct the coordinate position relative to the substrate. It is required that the axis of rotation be arranged at substantially right angles to the substrate. If this is not the case, the film thickness in the line width direction becomes uneven and the film thickness can be varied by the rotation of the drawing nozzle. It is appropriate that the cross-section of the paste discharging hole has a configuration substantially elongated, such as rectangle and elliptical configuration. It is also appropriate that a plurality of small circular holes are arranged in one or two lines to form a substantially wide paste discharging hole.

According to claim 4 an apparatus for forming a thick film circuit comprises a drawing head, an X-Y drive device for relatively moving the drawing head with respect to the substrate, and a control unit having a microprocessor for controlling each device. The drawing head has a drawing nozzle at the end portion thereof, which drawing nozzle has an elongated paste discharging hole. The drawing nozzle is arranged to be movable about an axis perpendicular to the substrate according to instructions of the control unit, wherein the center of the paste discharging hole is substantially coincident with the center of rotation of the drawing nozzle. More preferably, at least either the drawing head or a substrate holding device has an up-and-down drive device for changing the distance between the drawing nozzle and the substrate. The X-Y drive device is provided either at the substrate holding section or at the drawing head.

The thick film paste applicable to the present invention is a known conductor paste comprising metallic powder, glass frit, resin, organic solvent and so on, a known resistor paste replaced with ruthenium oxide or another metallic oxide instead of the metallic powder, or a known dielectric substrate paste. These pastes are generally burned at a temperature of 800 to 900°C and it is also appropriate to use a known cold cure type thick film paste comprising, for example, resin and metallic powder or resin and carbon.

The present invention will now be described in more detail with reference to the drawings, in which

Fig. 1 is a perspective view illustrating a prior art method of forming a thick film circuit;

Fig. 2 is a perspective view showing the end portion of the drawing nozzle of Fig. 1;

Fig. 3 is an illustration of the cross-section of a paste drawn with the prior art drawing nozzle of Fig. 1;

Fig. 4 is a cross-sectional view of a drawing head according to an embodiment of the present invention;

Fig. 5 is a perspective view of the end portion of a paste tank of Fig. 4;

Fig. 6 is an illustration of a method of forming a thick film circuit according to an embodiment of the present invention;

Fig. 7 is a plan view illustrating a method of forming a thick film circuit according to another embodiment of the present invention;

Fig. 8 is a diagram illustrating a control unit for controlling the method of forming a thick film circuit; and

Fig. 9 is an illustration of a cross-sectional profile found by a surface roughness measuring device after burning.

The embodiments of the present invention now will be described with reference to Figs. 4 to 8. A thick film paste 101 is provided in a drawing nozzle 102 acting as a paste tank, the drawing nozzle 102 being inserted into a head 103 and being screwed by a cap 110. The head 103 has a water jacket 107 performing circulation of constant-temperature water for keeping the temperature of the thick film paste 101 constant and is fixedly secured to a head base 109 by means of screws. The head base 109 has an air supplying inlet 106 for discharging the thick film paste 101 and a shaft 112 integrally attached to the head base 109. The shaft 112 is inserted into a passing-through hole 113 provided in a bracket 111 and is freely rotatable about an axis of rotation 108. The shaft 112 is associated with a servomotor (not shown) provided at the opposite side of the head 103 with respect to the passing-through hole 113 whereby the head base 109 can be rotated. The drawing nozzle is of cylindrical shape and has a paste discharging hole 104 at the end portion thereof, the discharging cross-section size of which is 1 mm × 0.1 mm, thereby making it possible to efficiently draw a wide circuit pattern. The axis of rotation 108 is positioned such that it is passing the center of the paste discharging hole 104. A diamond tip 105 is provided in the vicinity of the paste discharging hole 104 for constantly maintaining the distance between the paste discharging hole 104 and a substrate 100.

To draw a conductor pattern 114 as shown in Fig. 6, the head base 109 is rotated at the time of drawing operation by the servomotor so that the longitudinal direction of elongated cross-section of paste discharging hole 104 is substantially normal to the direction in which the drawing nozzle 102 is relatively moved with respect to the substrate 100, followed by bringing the drawing nozzle 102 close to the substrate 100. Thereafter, the thick film paste 101 is discharged from the paste discharging hole 104 by means of air pressure and approximately at the same time the drawing nozzle 102 is relatively moved in the direction parallel to the substrate 100 to draw the conductor pattern 114 on the substrate 100. In this case, the drawing nozzle 102 can relatively move in optional directions by an X-Y drive device under control of a control unit and, as illustrated in Fig. 6, the direction and position of the paste discharging hole 104 are varied as indicated by reference numerals 104a, 104b, 104c, 104d, and 105d so that the longitudinal direction of the paste discharging hole 104 is always normal to the direction of relative movement with respect to the substrate. The diamond tip 105 always goes first in the paste discharging hole moving direction and the direction and position of the diamond tip 105 is varied as indicated by reference numerals 105a, 105b, 105c, 105d, and 105e. On reaching the end of the drawn pattern, the air pressure is removed to terminate the discharging of the thick film paste and the drawing nozzle is lifted. Therefore, due to the rotation of the drawing nozzle 102, the line width of the circuit pattern becomes constant and it is not required to correct the coordinate of the drawing nozzle 102 relative to the substrate 100 in accordance with the direction of the paste discharging hole 104 because the position of the center of the paste discharging hole 104 relative to the substrate 100 is not varied irrespective of the change of the direction of the discharging hole 104.

To draw resistor patterns 116a and 116b illustrated in Fig. 7, the head base 109 is rotated by the servomotor at the time of the drawing operation so that the longitudinal direction of the paste discharging hole 104 is substantially normal to the direction in which the drawing nozzle 102 is relatively moved with respect to the substrate 100, followed by bringing the drawing nozzle 102 close to a predetermined position on the substrate 100 on which conductor patterns 115a to 115c have been formed. Thereafter, the thick film paste 101 is discharged from the paste discharging hole 104 by means of air-pressure and substantially at the same time the drawing nozzle 102 is relatively moved with respect to the substrate 100 in a drawing direction 117a to draw a resistor pattern 116a on the substrate 100. In this case, a diamond tip 105f goes first in the drawing direction in relation to a paste discharging hole 104f. When reaching the end of the drawing pattern, the air pressure is removed to stop discharging of the paste and the drawing nozzle is lifted, so that the drawing of the resistor pattern 116a is terminated. The head base 109 is rotated by the servomotor to change the direction of the drawing nozzle 102 counterclockwise by 90 degrees and the drawing nozzle 104 is similarly moved in a drawing direction 117b to draw the resistor pattern 116b. Therefore, due to rotation of the drawing nozzle 102, the resistor drawing in different directions can be achieved by using only one drawing nozzle. Furthermore, the center of the paste discharging hole 104 is coincident with the axis of rotation 108 and therefore it is not required to correct the coordinate of the drawing nozzle 102 relative to the substrate 100. The control unit for the embodiments of the present invention is illustrated in Fig. 8. Fig. 9 shows the cross-sectional profile of the resistor pattern drawn as illustrated in Fig. 7, which is measured by a surface roughness measuring device after burning.

**Claims**

1. A method of forming a thick film circuit on a substrate by discharging a thick film paste from a paste discharging hole provided in a drawing nozzle at one end of a drawing head while said drawing head is moved with respect to said substrate or vice-versa, thereby drawing a desired pattern, said paste discharging hole having an elongated configuration, said drawing nozzle being rotated about an axis of rotation perpendicular to said substrate so that the longitudinal direction of the hole is always normal to the direction in which said drawing head is moved, the axis of rotation of said drawing nozzle substantially passing through the centre of said paste discharging hole.

2. A method according to claim 1, wherein the cross-section of said paste discharging hole has rectangle or elliptical configuration.

3. A method according to claim 1 or 2, wherein the formation of said thick film pattern further comprises the successively repeatedly executed steps of:

bringing said drawing nozzle close to a desired position;

forming said thick film pattern on said substrate by discharging said thick film paste from said paste discharging hole while moving said drawing nozzle parallel to said substrate;

terminating the discharging of said thick film paste on reaching the end of the drawing operation; and

separating said drawing nozzle from said substrate.

4. An apparatus for forming a thick film circuit, said apparatus comprising a substrate holding device, a drawing head (103), an X-Y drive device for moving said drawing head with respect to a substrate (100) or vice-versa and a control unit having a microprocessor for controlling each of said devices, said drawing head (103) having a drawing nozzle (102) and said drawing nozzle having an elongated paste discharging hole (104) at the end portion thereof, said drawing nozzle being rotatable about an axis perpendicular to said substrate, the axis of rotation of said drawing nozzle substantially passing through the centre of said paste discharging hole.

**Patentansprüche**

1. Verfahren zum Bilden einer Dickfilmschaltung auf einem Substrat durch Entladen einer Dickfilmpaste aus einem in einer Zeichendüse an einem Ende eines Zeichenkopfs vorgesehenen Pasten-Entladungsloch unter gleichzeitigem Bewegen des Zeichenkopfs bezüglich des Substrats oder umgekehrt in der Weise, daß ein gewünschtes Muster gezeichnet wird, wobei das Pasten-Entladungsloch eine längliche Gestalt aufweist, wobei die Zeichendüse um eine senkrecht zum Substrat verlaufende Drehachse in der Weise gedreht wird, daß die Längsrichtung des Lochs stets senkrecht zur Bewegungsrichtung des Zeichenkopfs ist, und wobei die Drehachse der Zeichendüse im wesentlichen durch das Zentrum des Pasten-Entladungslochs verläuft.

2. Verfahren nach Anspruch 1, dadurch gekennzeichnet, daß der Querschnitt des Pasten-Entladungslochs rechteckige oder elliptische Form hat.

3. Verfahren nach Anspruch 1 oder 2, dadurch gekennzeichnet, daß bei der Bildung des Dickfilmmusters weiterhin folgende Schritte wiederholt und aufeinanderfolgend durchgeführt werden:

Bringen der Zeichendüse an eine gewünschte Position;

Bilden des Dickfilmmusters auf dem Substrat durch Entladen der Dickfilmpaste aus dem Pasten-Entladungsloch unter gleichzeitigem Bewegen der Zeichendüse parallel zum Substrat;

Beenden des Entladens der Dickfilmpaste bei Erreichen des Endes des Zeichenvorgangs; und

Entfernen der Zeichendüse von dem Substrat.

4. Gerät zum Bilden einer Dickfilmschaltung, mit einer Substrat-Haltevorrichtung, einem Zeichenkopf (103), einer X-Y-Antriebsvorrichtung zum Bewegen des Zeichenkopfs relativ zu einem Substrat (100) oder umgekehrt, sowie mit einer Steuereinheit mit einem Mikroprozessor zum Steuern aller vorgenannten Vorrichtungen, wobei der Zeichenkopf (103) eine Zeichendüse (102) und die Zeichendüse ein längliches Pasten-Entladungsloch (104) an einem Endteil von ihr aufweist, wobei ferner die Zeichendüse um eine senkrecht zum Substrat verlaufende Achse drehbar ist, und wobei schließlich die Drehachse der Zeichendüse im wesentlichen durch das Zentrum des Pasten-Entladungslochs verläuft.

**Revendications**

1. Procédé pour former un circuit sous forme d'un film épais sur un substrat en déchargeant une pâte de film épais à partir d'un trou de déchargement de pâte pratiqué dans une busette de traçage à une extrémité d'une tête de traçage, pendant que ladite tête de traçage est déplacée par rapport dudit substrat ou vice-versa, en traçant ainsi le motif désiré, ledit trou de déchargement de pâte ayant une configuration allongée, ladite busette de traçage tournant autour d'un axe de rotation perpendiculaire audit substrate de telle sorte que la direction longitudinale du trou soit toujours normale à la direction de déplacement de ladite tête de traçage, l'axe de rotation de ladite busette de traçage passant sensiblement par le centre dudit trou de déchargement de pâte.

2. Procédé selon la revendication 1, dans lequel la section transversale dudit trou de déchargement de pâte a une configuration rectangulaire ou elliptique.

3. Procédé selon la revendication 1 ou 2, dans lequel la formation dudit motif en film épais comprend de plus les étapes successives exécutées de façon répétitive: consistant à:

— amener ladite busette de traçage près d'une position désirée;

— former ledit motif en film épais sur ledit substrat en déchargeant ladite pâte de film épais dudit trou de déchargement de pâte, tout en déplaçant ladite busette de traçage parallèlement audit substrat;

— terminer le déchargement de ladite pâte de film épais en atteignant la fin de l'opération de traçage; et

— séparer ladite busette de traçage dudit substrat.

4. Appareil pour former un circuit de film épais, ledit appareil comprenant un dispositif de maintien du substrat, une tête (103) de traçage, un dispositif d'entraînement selon deux directions X Y pour déplacer ladite tête de traçage par rapport à une substrat (100) ou vice-versa, et une unité de commande ayant un microprocesseur pour commander chacun desdits dispositifs, ladite tête (103) de traçage ayant une busette (102) de traçage, et ladite busette de traçage ayant un trou allongé (104) de déchargement de pâte à son extrémité, ladite busette de traçage pouvant tourner autour d'un axe perpendiculaire audit substrat, l'axe de rotation de ladite busette de traçage passant sensiblement par le centre dudit trou de déchargement de pâte.

Fig. 1

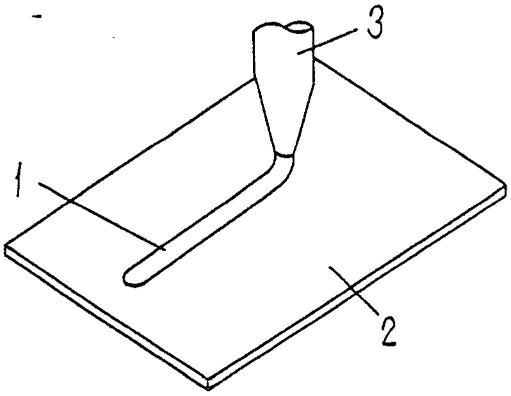


Fig. 2

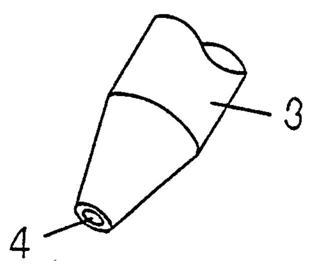


Fig. 3

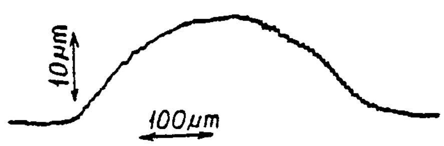

Fig.4

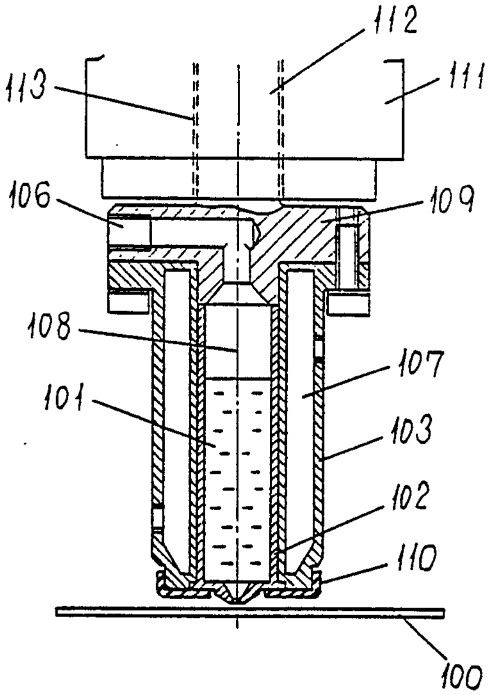
112
111
113
106
109
108
107
101
103
102
110
100

Fig.5

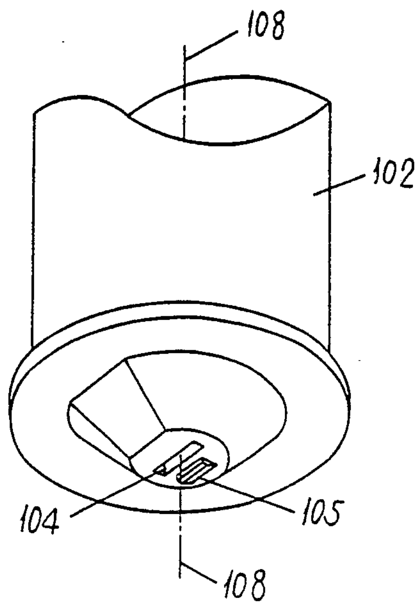
108
102
104
105
108

Fig.6

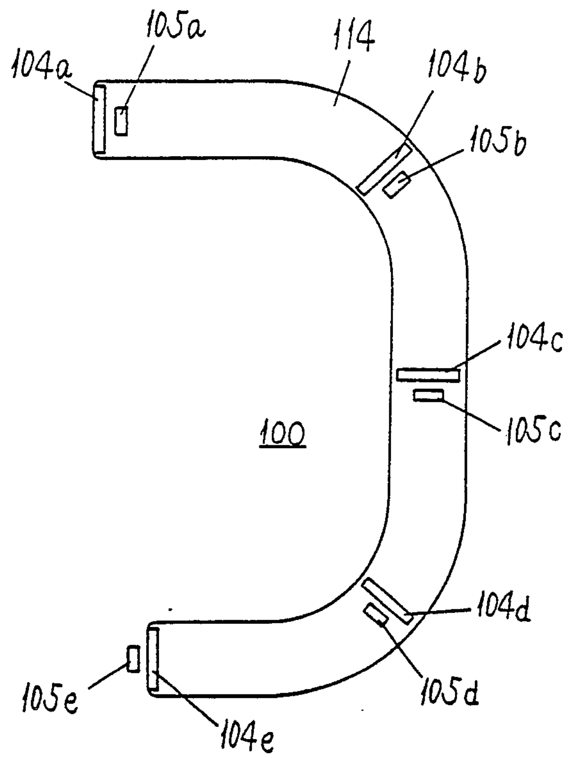
105a
114
104a
104b
105b
104c
105c
100
104d
105e
105d
104e

Fig.7

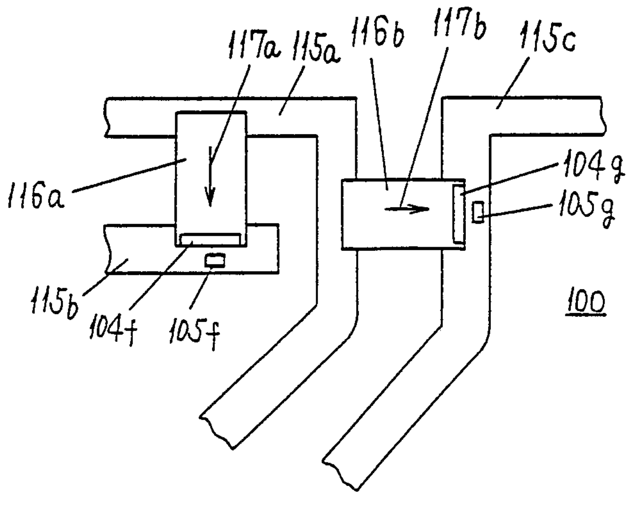
117a
115a
116b
117b
115c
104g
116a
105g
100
115b
104f
105f

Fig.8

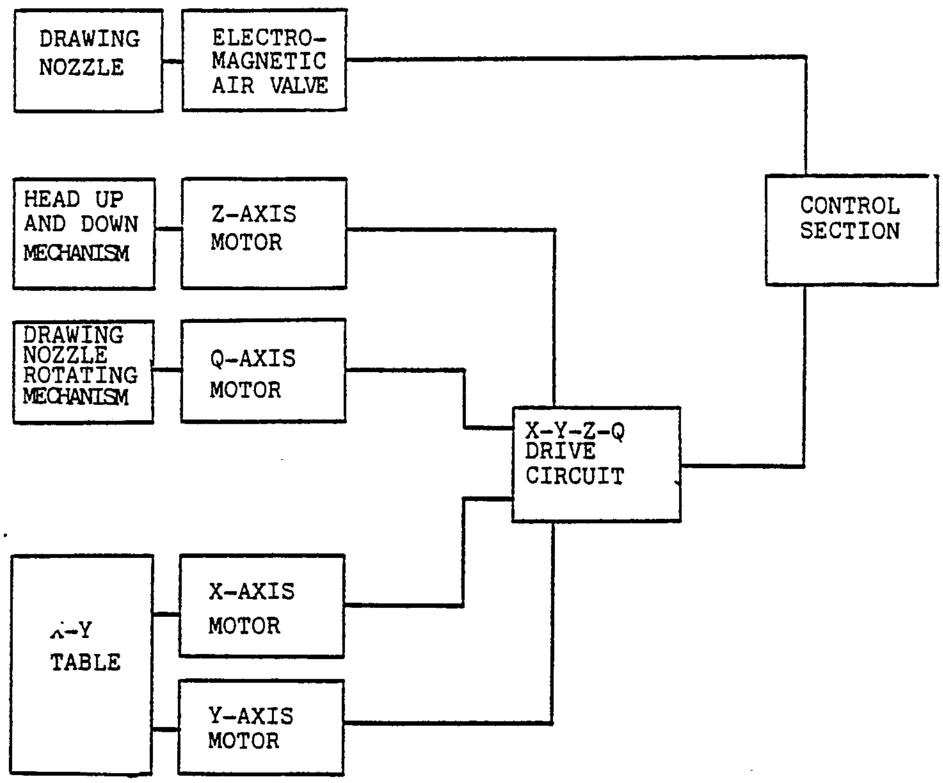
DRAWING NOZZLE
ELECTRO-MAGNETIC AIR VALVE
HEAD UP AND DOWN MECHANISM
Z-AXIS MOTOR
CONTROL SECTION
DRAWING NOZZLE ROTATING MECHANISM
Q-AXIS MOTOR
X-Y-Z-Q DRIVE CIRCUIT
X-Y TABLE
X-AXIS MOTOR
Y-AXIS MOTOR

Fig. 9

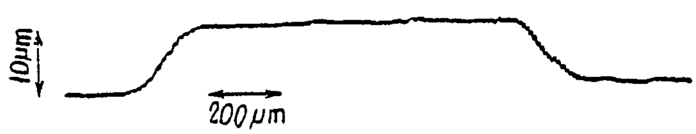
10μm
200μm